# EUROPEAN PATENT APPLICATION

(11) **EP 0 559 095 A1**
(43) Date of publication of application: **08.09.1993**
(21) Application number: 93103084.5
(22) Date of filing: 26.02.1993
(51) Int. Cl.: H03H 2/00, H01F 10/24

(54) **Material for magnetostatic-wave devices**

(30) Priority: 04.03.1992 JP 83322/92
(71) Applicant: MURATA MANUFACTURING CO., LTD., Nagaokakyo-shi Kyoto-fu 226 (JP)
(72) Inventor: Fujino, Masaru, Takatsuki-shi, Osaka-fu (JP); Mizuno, Shinobu, Nagaokakyo-shi, Kyoto-fu (JP); Aota, Mitsuhiro, Takefu-shi, Fukui-ken (JP); Kumatoriya, Makoto, Sendai-shi, Miyagi-ken (JP); Takagi, Hiroshi, Ohtsu-shi, Shiga-ken (JP)
(74) Representative: Schoppe, Fritz, Dipl.-Ing.

(57) **Abstract**

A material for magnetic garnet films used in magnetostatic-wave devices has a composition of a Y₃Fe₅O₁₂ system prepared by replacing a part Y³⁺ ions in Y₃Fe₅O₁₂ with metal ions capable of being incorporated as donor atoms into a crystal structure containing eight donor atoms, and/or by partially replacing Fe³⁺ ions in Y₃Fe₅O₁₂ with metal ions capable of being incorporated as donor atoms into a crystal structure containing six or four donor atoms.

## Description

### BACKGROUND OF THE INVENTION

### 1. Field of the Invention

The present invention relates to a material for magnetostatic wave devices and, more particularly, a material for ferrimagnetic garnet films used in magnetostatic wave devices.

### 2. Description of the Prior Art

In general, magnetostatic wave devices includes a ferrimagnetic thin film epitaxially grown on a substrate of gadolinium-gallium-garnet (GGG), Gd₃Ga₂(GaO₄)₃, by liquid-phase epitaxy techniques. As a material for ferrimagnetic thin films, there has widely been used yttrium-iron-garnet (YIG), Y₃Fe₂(FeO₄)₃. YIG films have a very small magnetic resonance half linewidth (ΔH), thus making it possible to minimize a difference between input and output signals of the magnetostatic wave devices.

However, the YIG films have a large temperature coefficient of saturation magnetization (4πMₛ) of about - 2100 ppm/°C. In order to compensate the temperature characteristics of magnetostatic-wave devices, it is required to combine a permanent magnet with a suitable temperature coefficient of magnetic field into a magnetostatic-wave device. Since there are limited kinds of permanent magnet materials, it is difficult to compensate the temperature characteristics of magnetostatic wave devices employing the YIG films.

### SUMMARY OF THE INVENTION

It is therefore a main object of the present invention to provide a material for forming magnetic garnet films used in magnetostatic-wave devices, which makes it easy to compensate temperature characteristics of magnetostatic wave devices.

The above and other objects of the present invention are achieved by providing a material having a composition of a Y₃Fe₅O₁₂ system prepared by partially replacing Y³⁺ ions in Y₃Fe₅O₁₂ with metal ions capable of being incorporated as a donor atom into a crystal structure containing eight donor atoms, and/or partially replacing Fe³⁺ ions in Y₃Fe₅O₁₂ with metal ions capable of being incorporated as a donor atom into a crystal structure containing six or four donor atoms.

The material for magnetic garnet films used in magnetostatic-wave devices according to the present invention may have a composition expressed by the general formula:

Y₃₋ₓMeₓFe_{5-y}Me'_{y}O₁₂

wherein Me is at least one metal selected from the group consisting of Gd, Bi, La and other metals capable of being incorporated as donor atoms into a crystal structure containing eight donor atoms, Me' is at least one metal selected from the group consisting of Ga, Al and other metals capable of being incorporated as donor atoms into a crystal structure containing six or four donor atoms, and wherein x and y take a value within the respective following ranges: 0 ≦ x ≦ 0.5, and 0 ≦ y ≦ 1.0.

The material of present invention makes it possible to produce a ferrimagnetic garnet films with a small temperature coefficient of saturation magnetization. Accordingly, it is possible with the material of present invention to perform temperature compensation of the characteristics of magnetostatic wave devices. In other words, the present invention makes it possible to use various kinds of permanent magnets with desired characteristics in magnetostatic wave devices.

The above and other objects, features and advantages of the present invention will be understood clearly from the following explanations with reference to several examples.

### BRIEF DESCRIPTION OF THE DRAWINGS

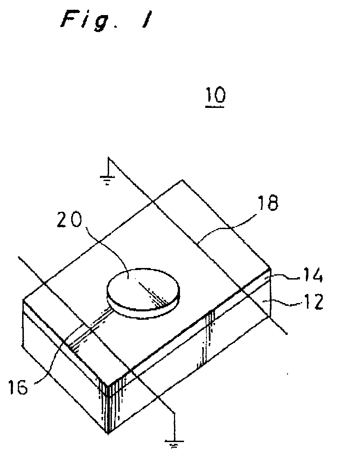

Fig. 1 is a perspective view of a magnetostatic wave devices employing a material for magnetic garnet films according to the present invention.

### DETAILED DESCRIPTION OF THE PREFERRED EMBODIMENTS

### Example

Powdered materials of Fe₂O₃, Y₂O₃, Bi₂O₃, Gd₂O₃, Al₂O₃ and Ga₂O₃ were weighed and mixed so that the product has a composition of the general formula:

Y₃₋ₓMeₓFe_{5-y}Me'_{y}O₁₂

with values of x and y as shown in Table 1. Each of the resultant mixture was added with a suitable amount of PbO and B₂O₃ serving as a solvent, put into a platinum crucible, and then heated to 1200 °C with a vertical electric furnace to prepare a homogeneous melt.

The melt was then cooled and kept at a constant temperature of about 900 °C to make the garnet into a supersaturated state. Then, the GGG substrate was immersed in the melt and rotated therein for a certain period of time to deposit a magnetic garnet film on the GGG substrate by the liquid-phase epitaxy. The substrate was then drawn up from the melt and rotated at a high rate of revolution to remove the melt from the surface of the magnetic garnet film.

For each of the resultant garnet film, measurements were made on saturation magnetisation (4πMₛ) and magnetic resonance half linewidth (ΔH) with an electron spin resonance analyzer. Results are shown in Table 1 together with a temperature coefficient (t.c.) of 4πMₛ. In the table, a specimen with an asterisk (*) is out of the scope of the present invention.

Using the respective magnetic garnet films, there were prepared magnetostatic wave devices as shown in Fig. 1. The magnetostatic wave device 10 shown in Fig. 1 includes a GGG substrate 12 of which one surface is provided with a magnetic garnet film 14 composed of the material having the composition shown in Table 1. Formed on the magnetic garnet film 14 are linear input and output transducers 16 and 18. Also, a permanent magnet 20 of a Ce system is arranged between input transducer 16 and output transducer 18 to apply a direct current magnetic field to the magnetic garnet film 14.

For each magnetostatic wave device, measurement was made on a temperature coefficient (t.c.) of center frequency (f_{c}=2400MHz) of the device. Results are also shown in Table 1.

**Table 1**

| No. | composition | 4πMₛ (G) | t.c. of 4πMₛ (ppm/°C) | t.c. of f_{c} (MHz/°C) | ΔH (Oe) |
|---|---|---|---|---|---|
| 1* | Y₃Fe₅O₁₂ | 1800 | -2100 | 2 | 0.6 |
| 2 | Y_{2.9}Bi_{0.1}Fe_{4.5}Ga_{0.5}O₁₂ | 820 | -2000 | 0.02 | 1.3 |
| 3 | Y_{2.6}Gd_{0.4}Fe₅O₁₂ | 1520 | -1500 | 0.03 | 2.0 |
| 4 | Y_{2.7}Gd_{0.3}Fe_{4.9}Al_{0.1}O₁₂ | 1200 | -1600 | 0.02 | 1.6 |

As will be understood from the data shown in Table 1, the magnetostatic wave device employing the magnetic garnet film composed of the material of the present invention is considerably small in temperature coefficient of center frequency. This results from the fact that the temperature coefficient of saturation magnetization (4πMₛ) of magnetic garnet films is reduced by use of the material having the composition falling within the scope of the present invention. Thus, it is possible to compensate the temperature characteristics of magnetostatic wave devices with ease by use of the material for magnetic garnet films of the present invention. This means that the present invention makes it possible to use various kinds of permanent magnets in combination with the material for magnetic garnet films of the present invention.

Although the present invention has been fully described in connection with the preferred embodiments thereof with reference to the accompanying drawings, it is to be noted that various changes and modifications are apparent to those skilled in the the art. Such changes and modifications are to be understood as included withing the scope of the present invention as defined by the appended claims unless they depart therefrom.

## Claims

1. A material for magnetic garnet films used in magnetostatic-wave devices, having a composition of a Y₃Fe₅O₁₂ system prepared by replacing a part of Y³⁺ ions in Y₃Fe₅O₁₂ with metal ions capable of being incorporated as donor atoms into a crystal structure containing eight donor atoms, and/or by partially replacing Fe³⁺ ions in Y₃Fe₅O₁₂ with metal ions capable of being incorporated as donor atoms into a crystal structure containing six or four donor atoms.

2. A material for magnetic garnet films used in magnetostatic-wave devices, having a composition expressed by the general formula:
Y₃₋ₓMeₓFe_{5-y}Me'_{y}O₁₂
wherein Me is at least one metal selected from the group consisting of Gd, Bi, La and other metals capable of being incorporated as donor atoms into a crystal structure containing eight donor atoms, Me' is at least one metal selected from the group consisting of Ga, Al and other metals capable of being incorporated as donor atoms into a crystal structure containing six or four donor atoms, and wherein x and y take a value within the respective following ranges: 0 ≦ x ≦ 0.5, and 0 ≦ y ≦ 1.0.
